**Europäisches Patentamt**

**European Patent Office**

**Office européen des brevets**

(19)

(11) Numéro de publication: **0 133 067
B1**

(12)

# FASCICULE DE BREVET EUROPEEN

(45) Date de publication du fascicule du brevet:
**21.02.90**

(21) Numéro de dépôt: **84401334.2**

(22) Date de dépôt: **26.06.84**

(51) Int. Cl.⁵: **G 11 B 20/10**, G 11 B 5/027,
G 11 B 27/30, G 11 B 7/007

(54) **Procédé et dispositif de remise en forme d'un signal de lecture de données enregistrées sur disque optique.**

(30) Priorité: **04.07.83 FR 8311072**

(43) Date de publication de la demande:
**13.02.85 Bulletin 85/7**

(45) Mention de la délivrance du brevet:
**21.02.90 Bulletin 90/8**

(84) Etats contractants désignés:
**DE GB IT NL SE**

(56) Documents cités:
**EP-A- 0 051 343
EP-A- 0 077 075
DE-A- 2 139 404
GB-A- 1 523 307
GB-A- 2 085 685**

**NEUES AUS DER TECHNIK, no. 5, 15 octobre 1979, page 2, article no. 542, Würzburg, DE; "Synchronisation des Datenbitstromes bei Aufzeichnung auf einem scheibenförmigen Aufzeichnungsträger"
Philips Technical Review, N 6, 1982, pages 157-164**

(73) Titulaire: **THOMSON-CSF, 51, Esplanade du Général de Gaulle, F-92800 Puteaux (FR)**

(72) Inventeur: **Romeas, René, THOMSON-CSF SCPI 173, bld Haussmann, F-75379 Paris Cedex 08 (FR)**
Inventeur: **Lecomte, Daniel, THOMSON-CSF SCPI 173, bld Haussmann, F-75379 Paris Cedex 08 (FR)**

(74) Mandataire: **Grynwald, Albert et al, THOMSON-CSF SCPI, F-92045 PARIS LA DEFENSE CEDEX 67 (FR)**

ACTORUM AG

## Description

La présente invention concerne un procédé de remise en forme d'un signal de lecture de données enregistrées sur un disque optique. Il est particulièrement applicable à la remise en forme des impulsions de synchronisation provenant d'informations préenregistrées sur le disque et servant à la remise en phase de l'horloge donnant les tops de lecture. L'invention concerne également un dispositif mettant en œuvre ce procédé.

Les méthodes d'enregistrement sont bien connues de l'homme de métier et sortent du cadre de la présente invention. Le plus souvent, ces informations sont enregistrées sous forme de microreliefs le long de pistes ayant la configuration de spirale ou de cercles concentriques. Elle facilite notamment l'accès aléatoire à une donnée enregistrée ainsi qu'un enregistrement divisé en blocs ou secteurs.

Lors d'enregistrements, les différents éléments binaires doivent être enregistrés à intervalles réguliers tout au long du disque. On doit donc disposer de moyens de synchronisation qui permettront ensuite lors de la lecture de détecter efficacement chaque élément enregistré. Pour ce faire, de nombreuses méthodes sont également connues.

Selon une première méthode, dans les systèmes dits multipistes, à chaque piste réservée à l'enregistrement d'information utile est associée au moins une autre piste le long de laquelle sont enregistrées diverses informations et notamment des signaux d'horloge permettant la synchronisation de la lecture de l'information utile. Dans une variante de réalisation, les pistes destinées à la synchronisation sont prégravées et comportent des perturbations régulièrement espacées décelables optiquement. Lors de la lecture, dans une première variante (système multifaisceau), un premier faisceau focalisé sur la piste d'information utile est utilisé pour lire ces informations, et un second faisceau, séparé mais en relation de couplage mécanique constant avec le premier, est utilisé pour lire les informations de synchronisation. Dans une seconde variante, (système monofaisceau) un seul faisceau lit les deux informations. Dans ce cas, il est nécessaire que les deux types d'informations puissent être aisément discriminés. A titre d'exemple, les spectres de fréquences associés à ces informations peuvent être différents. Dans cette variante les informations de synchronisation prégravées peuvent également être utilisées pendant la phase d'écriture.

Pour augmenter la densité d'enregistrement possible, il a été également proposé d'utiliser une seule piste. Dans ce cas, les signaux d'horloge de synchronisation peuvent être dérivés de la lecture de l'information ellemême.

Pour rendre plus aisée la synchronisation, on utilise classiquement des codes dits auto-synchronisants ou à maximum de transitions, quelque soit le contenu de l'information source à enregistrer. En effet, de façon pratique, les microreliefs présentent deux niveaux de référence, associés aux valeurs logiques «0» et «1» respectivement. Les signaux de synchronisation sont dérivés de la détection des transitions d'un niveau déterminé à l'autre et sont utilisés pour asservir en fréquence et en phase un oscillateur, classiquement de type à commande en tension (connu sous le sigle V.C.O., de l'expression anglo-saxonne «Voltage controlled oscillator») munie d'une boucle de rétroaction à verrouillage de phase (P.L.L.: «phase locked loop»). En outre, des salves spéciales d'impulsions enregistrées sont utilisées pour initialiser l'asservissement.

Cependant ce type de codage ne permet pas une densité maximale d'enregistrement. Il est également connu pour augmenter cette densité, d'utiliser des codes non auto-synchronisants par exemple le code N.R.Z. (non retour à zéro). Ce type de code a pour caractéristique de ne pas présenter de transition d'un bit d'information à l'autre si ces deux bits restent à la même valeur logique. Il est alors plus difficile de dériver, de la lecture de l'information ainsi codée, les signaux nécessaires à la synchronisation. On conaît néanmoins des moyens de synchronisation fonctionnant avec de tels codes. C'est ainsi que la demande de brevet EP-A-0 089 264 (publiée le 21.9.83 et par conséquent comprise dans l'état de la technique selon l'article 54(3) CBE) décrit un procédé et un dispositif dans lesquels des éléments de synchronisation ou «drapeaux» sont préenregistrés à intervalles réguliers le long des pistes du disque. A chaque passage d'un drapeau sous une tête de lecture les circuits opérateurs de signaux de synchronisation resynchronisent le système d'enregistrement-lecture et notamment une horloge fournissant les temps d'inscription-lecture. Pour cela, il convient de disposer de signaux de synchronisation de durée et de rapport cyclique sensiblement constants qui puissent être comparés à ceux des signaux d'horloge.

Comme on l'a vu précédemment, ces signaux de synchronisation proviennent d'éléments d'information préenregistrés sur le disque. Pour des questions d'organisation des informations sur le disque, deux éléments d'information de même valeur, l'un enregistré sur une piste périphérique, l'autre sur une piste centrale du disque, n'ont pas la même longueur. De plus, l'enregistrement de ces éléments d'information se fait soit par des moyens optiques, soit par matriçage et peut donner lieu à des distorsions. De même, la lecture est sujette à des déformations dues à des imperfections des systèmes de lecture auxquels sont appliquées certaines tolérances de fabrication concernant le rendement et la qualité des dispositifs optiques, la sensibilité des cellules et la puissance de la source lumineuse. Il est donc en général nécessaire de remettre en forme le signal de lecture.

Il a été proposé, notamment dans le brevet EP-A-0 077 075, un procédé de remise en forme d'un signal de données numériques enregistrées sur un disque. Ce procédé met en œuvre une boucle d'asservissement dans laquelle le seuil de détection du signal est ajusté afin de restituer la largeur du signal original. Pour ce faire, le procédé utilise une séquence particulière du signal original dans laquelle les signaux «0» et «1» sont de durées égales.

On a aussi proposé dans le brevet GB-A-2 085 685 un circuit de remise en forme d'un signal, ce circuit comportant entre autre un circuit de comparaison, un intégrateur et une boucle d'asservissement fermée.

L'invention a pour but de proposer un nouveau procédé de remise en forme d'un signal de lecture de données numériques ainsi qu'un dispositif pour sa mise en œuvre.

L'invention a pour objet un procédé de remise en forme d'un signal de lecture de données numériques enregistrées sur un disque optique comportant le long d'une piste des zones de données alternant avec des zones de prégravures de configuration particulière, ledit procédé consistant à générer un signal rectangulaire au moyen d'un circuit de comparaison recevant sur l'une de ses entrées ledit signal de lecture et sur une autre entrée une tension de réglage déterminant par comparaison les instants de commutation, comprenant les étapes suivantes:

a) choix d'une configuration des zones de prégravures correspondant à une suite alternée d'éléments binaires à un premier niveau logique et à un second niveau logique telle que la somme des durées au premier niveau logique et la somme des durées au second niveau logique sont dans un rapport déterminé égal à l'unité;

b) prélèvement de la portion de signal de lecture correspondant à l'une desdites zones de prégravure;

c) détermination de ladite tension de réglage à partir de ladite portion de signal de lecture afin que ledit signal rectangulaire reflète ce rapport prédéterminé;

d) maintien de ladite tension de réglage jusqu'au prélèvement d'une autre portion de signal de lecture;

e) caractérisé en ce que ladite tension de réglage est proportionnelle au résultat de l'intégration de ladite portion de signal de lecture.

L'invention sera mieux comprise et d'autres caractéristiques et avantages apparaîtront à l'aide de la description qui suit en référence aux figures annexées parmi lesquelles:

- la figure 1 représente schématiquement un appareil d'enregistrement-lecture dans lequel le dispositif de l'invention peut être mis en œuvre;
- la figure 2 représente un schéma d'organisation d'un disque optique utilisé dans le dispositif de l'invention;
- la figure 3 illustre par des courbes le procédé de l'invention;
- la figure 4 représente un exemple de réalisation du dispositif selon l'invention;
- la figure 5 illustre par des courbes le fonctionnement du dispositif selon l'invention;
- la figure 6 représente un exemple de réalisation détaillé du dispositif selon l'invention.

Les procédés d'inscription d'informations sur un disque optique sont bien connus. Habituellement le disque comporte au moins une couche, généralement superficielle, en matériau sensible à certains types de radiations. Selon un des procédés les plus connus, lors de l'inscription, on focalise un faisceau généré par une source laser sur cette couche de matériau et on crée par effet thermooptique des microreliefs le long des pistes. Ces pistes peuvent être virtuelles, c'est-à-dire être créées au moment de l'inscription des données, ou encore être prégravées sous quelque forme que ce soit. Les procédés de lecture des informations et de suivi de piste sont également bien connus. On utilise généralement pour le suivi de piste, soit un second faisceau de lecture, soit le faisceau ayant servi à l'écriture; ou encore le même faisceau sert pour toutes les fonctions. L'intéraction de ce faisceau avec les microreliefs défilant sous une tête de lecture crée des ordres d'interférences qui sont détectés par des moyens optoélectroniques de détection. La lecture peut se faire, soit par transmission au travers du disque et détection à l'aide de cellules photodétectrices placées à proximité de la face inférieure du disque, soit par réflexion du rayonnement sur le disque et retour inverse de la lumière reprise par des systèmes optiques comprenant des miroirs dirigeant les faisceaux réfléchis vers des cellules photodétectrices.

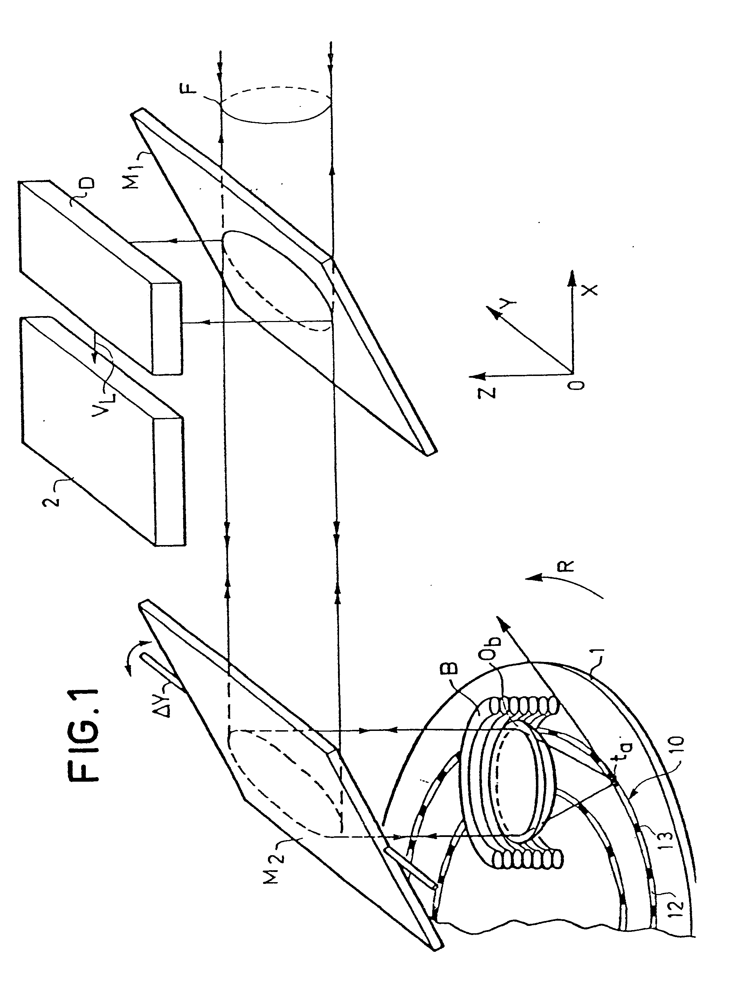

La figure 1 illustre de façon schématique un dispositif dans lequel un faisceau F, fourni par des moyens non représentés, traverse un premier miroir M1, est réfléchi par un deuxième miroir M2 vers un objectif de focalisation. Ob qui focalise le faisceau en un point ta situé sur une piste 10 d'un disque 1. Selon la nature de l'information située au point ta, le faisceau est réfléchi, puis retransmis par l'objectif Ob, les miroirs M2 et M1 vers un dispositif de détection D. Celui-ci est équipé de cellules photoélectriques qui traduisent l'intensité lumineuse du faisceau en un signal électrique VL. Le signal VL est transmis à un dispositif de lecture 2 qui traite le signal.

Le système de la figure 1 est muni de moyens de réglage tels qu'une bobine électromagnétique B pour déplacer axialement l'objectif Ob ou des moyens (non représentés) permettant d'orienter le miroir M2 autour de son axe $\Delta Y$.

Le disque 1 est animé d'un mouvement de rotation selon la flèche R. L'objectif Ob; voit donc défiler en son point de focalisation, les éléments d'information du disque.

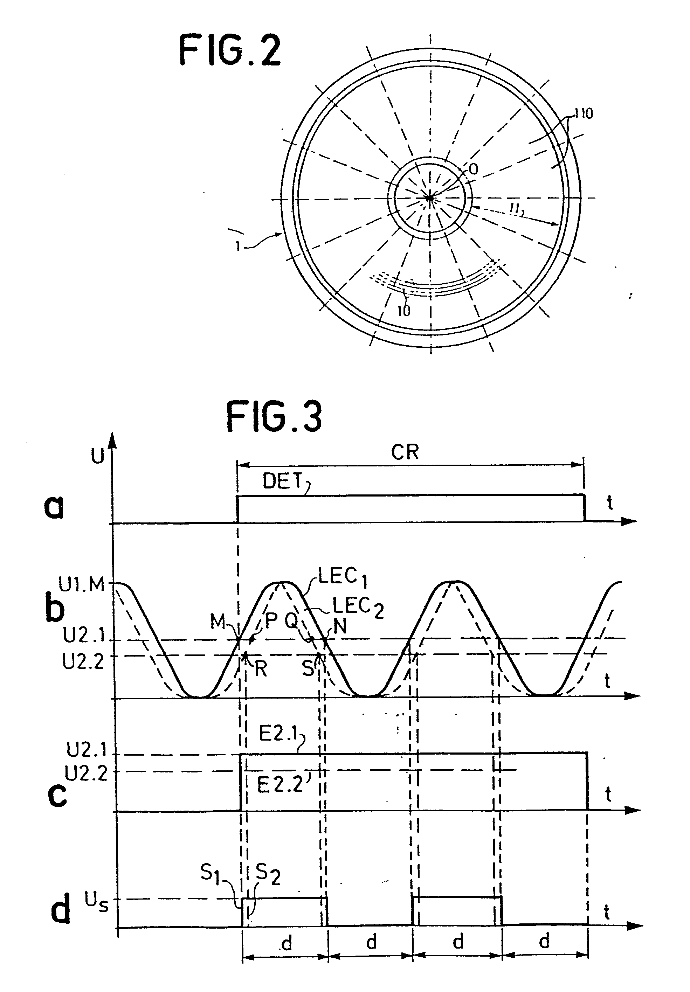

Comme représenté sur la figure 2, les pistes 10 occupent selon le rayon du disque un espace 11. A titre d'exemple, sur un disque de 30 cm de diamètre, cet espace pourra être de 8 cm et les pistes inscrites seront au nombre d'environ 40000.

L'ensemble du disque 1 est divisé en secteurs angulaires tel que le secteur 110. Selon l'exemple de la figure 2, on a 16 secteurs. Chaque piste 10 est donc divisée en 16 plages d'enregistrement. Les différentes plages de piste appartenant à un même secteur contiennent ou sont susceptibles de contenir (si elles ne sont pas encore enregistrées) un même nombre d'éléments d'information. Un secteur d'une piste périphérique du disque contient un même nombre d'éléments d'information qu'un secteur d'une piste plus proche du centre O du disque. Les longueurs des éléments d'information sont donc plus courtes pour les pistes centrales que pour les pistes périphériques.

Les informations enregistrées ou à enregistrer sur les plages de chaque piste 10 sont arrangées en blocs de 64 éléments binaires tel que le bloc 12 sur la figure 1. Les différents blocs sont séparés par une information caractéristique 13 identifiable en tant que telle appelée drapeau. Ces drapeaux permettent d'ordonner l'inscription et la lecture des informations sur le disque. Ils permettent également d'effectuer une synchronisation des dispositifs d'enregistrement-lecture en fonction de la vitesse de défilement des informations sous l'objectif Ob. En effet, notamment dans le cas de codes N.R.Z. comme décrit précédemment, une horloge doit donner les instants d'inscription et de lecture des éléments binaires pour commander les instants de changement d'état sur le support d'enregistrement (lors de l'enregistrement) ou commander les échantillonnages des signaux lus (lors de la lecture). Il faut donc que les impulsions fournies par l'horloge à cet effet soient calées en fréquence et en phase par rapport à une base donnée.

Les drapeaux, enregistrés sur le disque préalablement à tout enregistrement d'informations utiles, donneraient pour chaque bloc 12 d'éléments binaires, cette base de mise en synchronisme de fréquence et de remise en phase de l'horloge.

Un drapeau est constitué d'une succession connue d'états binaires de valeurs différentes «0» ou «1» ayant chacun une durée déterminée.

La détection d'un tel drapeau se fait à l'aide de circuits connus dans la technique. On connaît également des systèmes de synchronisation en fréquence de l'horloge par rapport à un ou plusieurs éléments particuliers du drapeau.

Par contre, en ce qui concerne la remise en phase de l'horloge, si les éléments constituant le drapeau ont subi une distorsion soit lors du pré-enregistrement, soit lors de la lecture, le réglage en fréquence peut être modifié à tort. Celà est le cas notamment lorsque le rapport cyclique du signal lu, c'est-à-dire le rapport de la durée d'un élément à l'état «0» et de la durée d'un élément à l'état «1» varie par rapport à une valeur nominale.

C'est pourquoi l'invention fournit un procédé, illustré par la figure 3, permettant lors de la remise en forme d'un signal de lecture, de corriger des variations de rapports cycliques.

Pour simplifier, on a considéré un drapeau constitué d'éléments binaires de valeur «1» alternés avec des éléments binaires de valeur «0», ces éléments ayant tous une même durée et leur rapport cyclique ayant pour valeur l'unité.

Ce drapeau donne lieu, après lecture par le dispositif de la figure 1 et après détection par des moyens qui sortent du cadre de l'invention, à un signal de lecture LEC1 de la forme représentée par la courbe (b) de la figure 3. Ce signal est considéré comme n'ayant pas subi de déformation de son rapport cyclique lequel a pour valeur l'unité. Le signal LEC1 présente des flancs de montée et de descente inclinés. Celà est dû au mode de lecture optique des informations sur le disque et au système de transmission optique dans la tête de lecture. Cette inclinaison des signaux de lecture est généralement un inconvénient. L'invention au contraire exploite cette inclinaison.

Selon l'invention, on détermine un temps CR tel que la somme des temps durant lesquels le signal de lecture LEC1 est à un niveau logique déterminé «0» par exemple, égal à la somme des temps durant lesquels ce même signal est à un autre niveau logique «1», par exemple. Sur la courbe (a) de la figure 3 on à choisi à titre d'exemple un signal DET de durée CR égale à l'équivalent de deux éléments binaires «0» et de deux éléments binaires «1».

Durant ce temps CR, le signal LEC1 est intégré et donne lieu à un signal de tension E2.1 représenté par la courbe (c) de la figure 3 dont le niveau de tension U2.1 représente un niveau de tension moyen du signal LEC1. Les deux signaux LEC1 et E2.1 sont soustraits l'un de l'autre; la partie positive de la différence est amplifiée puis écrêtée à un niveau de tension Us de façon à donner un signal rectangulaire. En reportant le niveau de tension U2.1 sur la courbe (b), on obtient sur le signal LEC1 des points tels que M et N délimitant la durée du signal rectangulaire à obtenir. Sur la courbe (d) de la figure 3, on a représenté ce signal S1 résultant. Comme mentionné précédemment, le signal LEC1 étant d'allure régulière, on a une symétrie du signal par rapport au niveau U2.1. Le signal S1 a donc une forme régulière avec des impulsions d'amplitude Us et de durée t, et des intervalles de durée t entre impulsions. Son rapport cyclique est donc 1.

On considère maintenant un signal de lecture déformé par rapport au signal LEC1 mais en phase avec celui-ci. Celui-ci est, par exemple, un signal LEC2, tel que représenté par la courbe (b) en pointillé de la figure (3), dont le rapport cyclique diffère de celui du signal LEC1.

Tout d'abord on remarque, sur la figure 3, que si l'on gardait pour la mise en forme du signal LEC2, le même seuil de tension de mise en forme que pour le signal LEC1, on obtiendrait un niveau U2.1 dont les points d'inter sections P et Q avec la courbe LEC2 déterminerait un créneau nettement différent de celui déterminé par le points M et N.

Par contre, selon l'invention, le signal LEC2 est intégré. Il donne lieu à un niveau de tension U2.2 sur la courbe (c) de la figure 3. Ce niveau, reporté sur la courbe (b), coupe la courbe LEC2 en deux points R et S. Les pentes des flancs de montée et de descente des signaux LEC1 et LEC2 sont sensiblement égales et sont telles en raison de la nature du système de lecture, que les points R et S sont très rapprochés en projection sur l'axe des abscisses t, des points M et N respectivement par comparaison aux points P et Q. Les signaux LEC2 et E2.2 sont soustraits l'un de l'autre. La partie positive est amplifiée et écrêtée. On obtient ainsi un signal S2, en pointillé sur la courbe (d) de la figure 3, qui diffère peu du signal S1. Le signal S2 a donc un rapport cyclique peu différent de celui du signal S1. Le procédé de l'invention, lors de la mise en forme d'un signal de lecture, a donc permis de corriger une déformation du signal de lecture, telle qu'une variation de rapport cyclique, et d'obtenir, pour des signaux de lecture en phase, des signaux mis en forme sensiblement identiques.

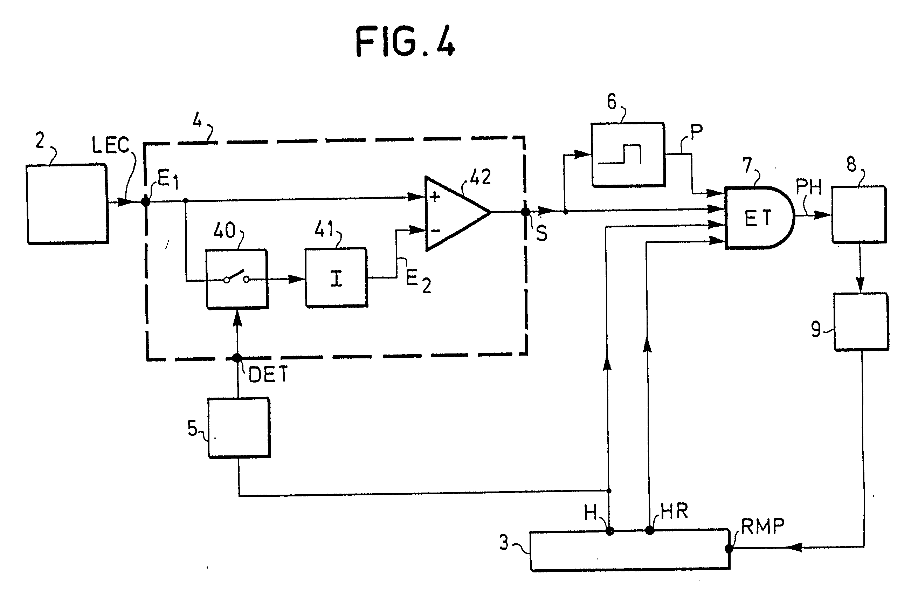

Le procédé de l'invention peut être mis en œuvre par le dispositif de la figure 4.

On retrouve sur cette figure le dispositif de lecture 2 de la figure 1 fournissant sur sa sortie LEC des signaux de lecture tels que représentés sur la courbe (b) de la figure 3.

La sortie LEC du dispositif 2 est connectée à une entrée E1 d'un dispositif de mise en forme 4. Ce dispositif 4 comprend un commutateur 40 fonctionnant sous la commande de signaux reçus sur l'entrée DET, un circuit intégrateur 41 intégrant les signaux fournis par le commutateur 40, un circuit de comparaison 42 possédant deux entrées et fournissant sur une sortie S un signal rectangulaire de niveau déterminé selon les niveaux des signaux d'entrée.

Le dispositif de la figure 4 comporte en outre: une horloge 3 délivrant des signaux H et HR à remettre en phase; un circuit de commande 5 du commutateur 40; un circuit de temporisation 6 connecté à la sortie S, une porte 7 de type ET dont les entrées sont connectées à la sortie S, au circuit de temporisation 6 et à l'horloge 3; et enfin un circuit de calcul de déphasage 8 et un circuit de commande de phase 9 connectés à la sortie de la porte ET.

Le dispositif de lecture 2 délivre sur sa sortie LEC un signal, LEC1 par exemple, du type représenté sur la courbe (b) de la figure 3, provenant de la lecture du disque 1.

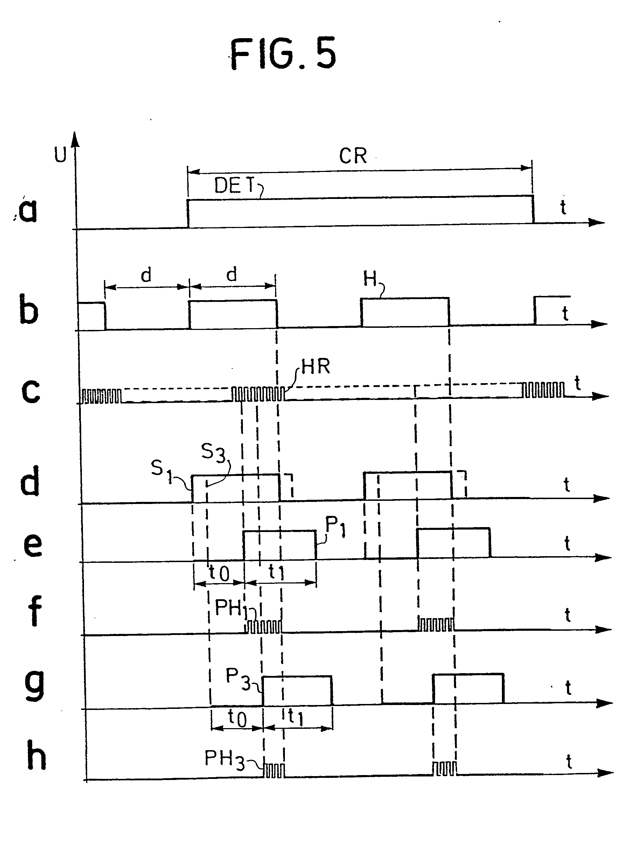

L'horloge 3 délivre en permanence sur ses sorties H et HR des signaux tels que représentés respectivement sur les courbes (b) et (c) de la figure 5. A titre indicatif, la fréquence du signal HR est 16 fois la fréquence du signal H. La durée d'une impulsion H, ainsi que l'intervalle entre impulsions ont pour valeur la durée d d'un élément «0» ou «1» d'un signal de lecture.

Des moyens non représenté et qui sortent du cadre de l'invention permettent de détecter les maxima du signal LEC1 et d'effectuer un réglage approché en phase des signaux d'horloge H sur les signaux LEC1. Le dispositif de l'invention va donc permettre d'affiner ce réglage en phase.

Les signaux H sont transmis à un circuit de commande 5. Celui-ci compte le nombre de signaux H de façon à déterminer les positions dans le temps présumé des drapeaux sur le disque 1. A ces instants, le circuit de commande 5 transmet un signal de commande DET à l'entrée DET du dispositif de mise en forme 4. Ce signal DET représenté par la courbe (a) de la figure 5 a une durée CR égale à quatre fois la durée d. Le signal DET commande la fermeture du commutateur. Pendant le temps CR, le circuit intégrateur 41 est connecté à l'entrée E1. Le signal LEC1 est intégré par l'intégrateur 41. Celui-ci fournit un signal E2.1, représenté sur la courbe (c) de la figure 3, à l'entrée négative du circuit de comparaison 42. L'entrée positive de ce même circuit reçoit par ailleurs le signal LEC1. Le circuit de comparaison 42 fournit en échange un signal S1 rectangulaire représenté sur la courbe (d) de la figure 3 et sur la courbe (d) de la figure 5.

Le signal S1 est transmis au circuit de temporisation 6. Au bout d'un temps t0, à partir du flanc avant d'une impulsion positive du signal S1, le circuit de temporisation 6 fournit une impulsion P1 de durée t1 sur sa sortie P. La porte 7 de type ET établi la coïncidence entre les signaux reçus sur ces entrées à savoir: le signal S1, le signal P1, les signaux d'horloge H et HR. Pendant le temps où les signaux S1, P1 et H sont à un niveau logique 1, la porte 7 laisse passer des impulsions d'horloge HR. Le signal PH1 fourni, et représenté par la courbe (f) de la figure 5, est constitué d'impulsions dont le nombre est caractéristique du déphasage existant entre le signal S1, donc du signal de lecture LEC1, et le signal d'horloge H. Les impulsions PH1 sont transmises à un compteur 8 où elles sont comptées. Le nombre obtenu est transmis à un circuit de commande de phase 9 qui interprète le résultat. Le signal S1 étant en phase avec le signal d'horloge H, le circuit 9 ne fournit aucune commande.

Si le signal de lecture et le signal d'horloge H sont déphasés, on obtient à la sortie S du circuit 4 de la figure 3, un signal S3 tel que représenté en pointillé sur la courbe (d) de la figure 5. Le flanc avant du signal S3 déclenche le circuit 6 qui fournit après un temps t0, un signal P3 de durée t1 comme représenté par la courbe (g) de la figure 5.

La mise en coïncidence dans la porte 7 des signaux H, HR, P3 et S3 donne lieu à un signal PH3 représenté par la courbe (h) de la figure 5. Le nombre d'impulsions constituant PH3 diffère du nombre d'impulsions du signal PH1. Le circuit de commande de phase 9 interprète le résultat et donne une commande appropriée sur l'entrée RMP pour provoquer une remise en phase de l'horloge.

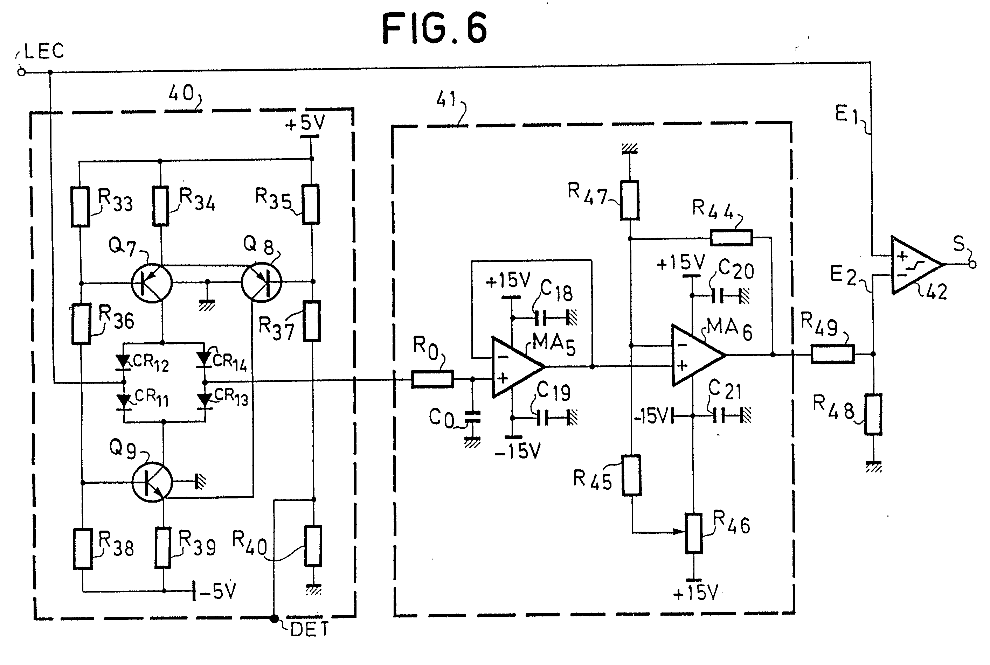

Pour illustrer l'invention, un exemple de réalisation concrète du dispositif 4 de mise en forme et particulièrement du commutateur 40, de l'intégrateur 41, du circuit de comparaison 42 est représenté en figure 6.

Le commutateur 40 est constitué de circuits de commutation à transistors Q7, Q8, Q9 commandés par un pont de résistances R35, R37, R40 recevant le signal de commande DET. Le fonctionnement des transistors Q7, Q8, Q9 convenablement polarisés commande la conduction du pont de diodes CR11, CR12, CR13, CR14. Un signal de lecture reçu sur l'entrée LEC est transmis à l'intégrateur 41.

L'intégrateur 41 est essentiellement constitué

d'une résistance R0 et d'un condensateur C0 dont l'une des bornes est connectée à la terre. Le condensateur C0 se charge durant les niveaux positifs du signal de lecture et se décharge durant les niveaux négatifs ou nuls. Pour obtenir une intégration convenable du signal de lecture, les valeurs de la résistance R0 et du condensateur C0 sont choisies de façon à avoir une constante de temps du circuit appropriée aux durées des éléments binaires constituant le signal de lecture. A titre d'exemple pour une durée d'élément binaire du signal de lecture de 200 ns on choisit un condensateur C0 de 1 nF et une résistance R0 de 10 KΩ. L'intégrateur 41 comporte en outre deux amplificateurs MA5 et MA6 et leurs circuits de polarisation dont le rôle est de réguler le niveau du signal fourni par l'ensemble résistance R0-condensateur C0.

Enfin le circuit de comparaison est constitué d'un amplificateur opérationnel 42 et d'un pont de résistances d'entrée R48–R49. L'amplificateur 42 fonctionne en régime de saturation.

## Revendications

1. Procédé de remise en forme d'un signal de lecture de données numériques enregistrées sur un disque optique (1) comportant le long d'une piste (10) des zones des données (110) alternant avec des zones de prégravures de configuration particulière, ledit procédé consistant à générer un signal rectangulaire (S) au moyen d'un circuit de comparaison (42) recevant sur l'une de ses entrées ledit signal de lecture (LEC) et sur une autre entrée (E2) une tension de réglage déterminant par comparaison les instants de commutation, comprenant les étapes suivantes:

a) choix d'une configuration des zones de prégravures correspondant à une suite alternée d'éléments binaires à un premier niveau logique et à un second niveau logique telle que la somme des durées au premier niveau logique et la somme des durées au second niveau logique sont dans un rapport déterminé égal à l'unité;

b) prélèvement de la portion de signal de lecture correspondant à l'une desdites zones de prégravure;

c) détermination de ladite tension de réglage à partir de ladite portion de signal de lecture afin que ledit signal rectangulaire reflète ce rapport prédéterminé;

d) maintien de ladite tension de réglage jusqu'au prélèvement d'une autre portion de signal de lecture (LEC);

e) caractérisé en ce que ladite tension de réglage est proportionnelle au résultat de l'intégration de ladite portion de signal de lecture (LEC).

2. Procédé selon la revendication 1, caractérisé en ce que l'intervalle de temps (CR) assigné audit prélèvement est déterminé par la détection desdites zones de prégravures.

3. Procédé selon les revendications 1 ou 2, caractérisé en ce que, pour remettre en phase l'horloge de synchronisation d'un disque optique par rapport au signal de lecture remis en forme, pendant un temps déterminé (t1) déclenché par le signal de lecture remis en forme (S), on met en coïncidence le signal de lecture remis en forme (S), le signal d'horloge de synchronisation (H) et des impulsions-horloge (HR) de fréquence multiple de la fréquence du signal d'horloge (H) de manière à déterminer la valeur du déphasage entre le signal de lecture et le signal d'horloge (H), puis on utilise cette valeur pour remettre en phase le signal d'horloge (H).

4. Dispositif pour la mise en œuvre du procédé selon l'une des revendications 1 à 3, comprenant un dispositif de lecture (2) fournissant un signal de lecture (LEC1, LEC2), et un circuit de comparaison (42) possédant une première entrée connectée au dispositif de lecture (2) sur laquelle il reçoit directement le signal de lecture (LEC1, LEC2) et une deuxième entrée connectée à la sortie d'un intégrateur (41), ce circuit de comparaison (42) fournissant en échange des signaux reçus sur ses deux entrées, un signal rectangulaire mis en forme caractérisé en ce qu'il comprend en outre un commutateur (40) commandé permettant de connecter le dispositif de lecture (2) à l'intégrateur (41) lequel reçoit aussi le signal de lecture (LEC1, LEC2) et de fournir en échange sur une sortie un niveau de tension moyen du signal de lecture et un dispositif de commande (5) déterminant l'intervalle de temps de mesure (CR) et commandant pendant ce temps la fermeture du commutateur (40).

5. Dispositif selon la revendication 4, comportant une horloge (3) dont les signaux sont à mettre en phase avec le signal de lecture (LEC1), caractérisé en ce que l'horloge (3) fournit, sur une première sortie, un premier signal d'horloge (H) déterminant les instants de lecture sur le disque ainsi que sur une deuxième sortie, un deuxième signal d'horloge (HR) de fréquence supérieure au premier; et en ce qu'il comprend un circuit de coïncidence (7) connecté à la sortie (LEC) du dispositif de lecture ainsi qu'aux premières et deuxièmes sorties de l'horloge (3) et fournissant sur une sortie (PH) des impulsions du deuxième signal d'horloge (HR) lorsqu'il y a coïncidence entre le signal de lecture (LEC1) et le premier signal d'horloge (H), des dispositifs de mesure (8 et 9) connectés à la sortie (PH) du circuit à coïncidence (7) pour compter le nombre d'impulsions du deuxième signal d'horloge (HR) et élaborer en conséquence des signaux pour la commande de mise en phase de l'horloge (3).

## Patentansprüche

1. Verfahren zur Wiederherstellung der Form eines Lesesignals von digitalen Daten, die auf einer optischen Platte (1) aufgezeichnet sind, mit entlang einer Spur (10) angeordneten Datenzonen (110), die mit Vorgravurzonen besonderer Konfiguration abwechseln, wobei das Verfahren in der Erzeugung eines Rechtecksignals (S) mit Hilfe einer Vergleichsschaltung (42) besteht, die an einem ihrer Eingänge das Lesesignal (LEC) und an einem anderen Eingang (E2) eine Steuerspannung empfängt, welche durch Vergleich die Schaltzeitpunkte bestimmt, und wobei das Verfahren folgende Schritte aufweist:

a) Wahl einer Konfiguration der Vorgravurzonen, die einer alternierenden Folge von Bits mit einem ersten logischen Pegel und Bits mit einem zweiten logischen Pegel entspricht, derart, dass die Summe der Präsenszeiten des ersten logischen Pegels und die Summe der Präsenszeiten des zweiten logischen Pegels in einem festgelegten Verhältnis gleich eins stehen,

b) Abgreifen desjenigen Abschnittes des Lesesignals, der einer der Vorgravurzonen entspricht,

c) Bestimmen der Steuerspannung auf Grund dieses Lesesignalabschnitts, damit das Rechtecksignal das vorausbestimmte Verhältnis wiederspiegelt,

d) Aufrechterhaltung der Steuerspannung bis zum Abgreifen eines anderen Lesesignalabschnitts (LEC),

e) dadurch gekennzeichnet, dass die Steuerspannung dem Ergebnis der Integration des Lesesignalabschnitts (LEC) proportional ist.

2. Verfahren nach Anspruch 1, dadurch gekennzeichnet, dass das dem Abgeifen zugewiesene Zeitintervall (CR) durch die Erfassung der Vorgravurzonen bestimmt wird.

3. Verfahren nach Anspruch 1 oder 2, dadurch gekennzeichnet, dass man das wieder in Form gebrachte Lesesignal (S), das Synchronisationstaktsignal (H) und Taktimpulse (HR) einer Frequenz, die ein Vielfaches der Frequenz des Taktsignals (H) beträgt, in Koinzidenz bringt, um den Synchronisationstakt einer optischen Platte in Bezug auf das wieder in Form gebrachte Lesesignal während einer festgelegten Zeit (t1), welche durch das wieder in Form gebrachte Lesesignal (S) ausgelöst wird, wieder in Phase zu bringen, derart, dass der Wert der Phasenverschiebung zwischen dem Lesesignal und dem Taktsignal (H) bestimmt und anschliessend zum In-Phase-Bringen des Taktsignals (H) benutzt wird.

4. Vorrichtung zur Durchführung des Verfahrens nach einem der Ansprüche 1 bis 3, mit einer Lesevorrichtung (2), welche ein Lesesignal (LEC1, LEC2) liefert, und einer Vergleichsschaltung (42), welche einem ersten an die Lesevorrichtung (2) angeschlossenen Eingang, über den sie direkt das Lesesignal (LEC1, LEC2) zugeführt erhält, und einen zweiten, an den Ausgang eines Integrators (41) angeschlossenen Eingang besitzt, wobei die Vergleichsschaltung (42) aufgrund der an ihren beiden Eingängen anliegenden Signale ein in Form gebrachtes Rechtecksignal liefert, dadurch gekennzeichnet, dass die Vorrichtung weiter einen gesteuerten Umschalter (40), der es ermöglicht, die Lesevorrichtung (2) an den Integrator (41) anzuschliessen, der ebenfalls das Lesesignal (LEC1, LEC2) empfängt und dafür an einem Ausgang einen mittleren Spannungspegel des Lesesignals liefert, und sie eine Steuervorrichtung (5) aufweist, die das Messzeitintervall (CR) bestimmt und während dieser Messzeit die Schliessung des Umschalters (40) steuert.

5. Vorrichtung nach Anspruch 4, mit einem Taktgeber (3), dessen Signale in Phase mit dem Lesesignal gebracht werden müssen, dadurch gekennzeichnet, dass der Taktgeber (3) an einen ersten Ausgang ein erstes Taktsignal (H), welches die Lesezeitpunkte auf der Platte bestimmt, und an einen zweiten Ausgang ein zweites Taktsignal (HR) mit einer höheren Frequenz als der ersten Frequenz liefert, und dass die Vorrichtung eine Koinzidenzschaltung (7), die an den Ausgang (LEC) der Lesevorrichtung sowie an den ersten und den zweiten Ausgang des Taktgebers (3) angeschlossen ist und an einem Ausgang (PH) Impulse des zweiten Taktsignals (HR) liefert, wenn Koinzidenz zwischen dem Lesesignal (LEC1) und dem ersten Taktsignal (H) herrscht, und Messvorrichtungen (8 und 9) besitzt, welche an den Ausgang (PH) der Koinzidenzschaltung angeschlossen sind, um die Anzahl der Impulse des zweiten Taktsignals (HR) zu zählen und dementsprechend Signale zum In-Phase-Bringen des Taktgebers (3) zu erzeugen.

## Claims

1. A method for shaping a read-out signal of digital data recorded on an optical disk (1) comprising, disposed along a track (10), data zones (110) which alternate with pre-engraved zones of particular configuration, said method consisting in generating a rectangular signal (S) by means of a comparator circuit (42) which receives said read-out signal (LEC) at one of its inputs and a control voltage at another input (E2), said control voltage being adapted to determine the switching instants by comparison, the method comprising the following steps:

a) choice of a configuration of the pre-engraved zones, which correspond to an alternating sequence of bits of a first logic level and bits of a second logic level, such that the sum of durations of the first logic level and the sum of durations of the second logic level are mutually related by a fixed ratio equal to unity,

b) picking up the portion of the reading signal that corresponds to one of said pre-engraved zones,

c) determination of said control voltage from said portion of the read-out signal so that said rectangular signal reflects the predetermined ratio,

d) maintaining said control voltage until picking-up of another portion of the read-out signal (LEC),

e) characterized in that said control voltage is proportional to the result of integration of said portion of the reading signal (LEC).

2. A method according to claim 1, characterized in that the time interval (CR) allocated to said picking-up is determined by the detection of said pre-engraved zones.

3. A method according to claim 1 or 2, characterized in that, in order to readjust the phase of the synchronization clock of an optical disk relative to the shaped read-out signal, during a predetermined time (t1) triggered by the shaped read-out signal (S), the latter signal (S), the synchronization clock signal (H) and clock pulses (HR) having a multiple frequency of the frequency of the clock signal (H) are brought into coincidence, such as to determine the value of phase shift between the read-out signal and the clock signal (H), with subsequently using this value for readjusting the phase of the clock signal (H).

4. A device for implementing the method according to anyone of claims 1 to 3, comprising a reading device (2) for providing a read-out signal (LEC1, LEC2), and a comparator circuit (42) having a first input connected to the reading device (2) and receiving directly the read-out signal (LEC1, LEC2), and having a second input connected to the output of an integrator (41), said comparator circuit (42) being adapted to provide in exchange for the signals received at its two inputs a shaped rectangular signal, characterized in that the device further comprises a controlled switch (40) allowing the reading device (2) to be connected to the integrator (41), which integrator also receives the read-out signal (LEC1, LEC2), and to provide at an output in exchange an intermediate voltage level of the read-out signal, and a control device (5) determining the measuring time interval (CR) and controlling the closing of the switch (40) during this time interval.

5. A device according to claim 4, comprising a clock (3), whose signals are to be adjusted in phase with the read-out signal, characterized in that the clock (3) delivers on a first output a first clock signal (H) which dertermines the instants for reading from the disk, and on a second output a second clock signal (HR) having a higher frequency than the first clock signal, and that the device comprises a coincidence circuit (7), which is connected to the output (LEC) of the reading device as well as to the first and second outputs of and which delivers on an output (PH) pulses of the second clock signal (HR), when there is coincidence between the read-out signal (LEC1) and the first clock signal (H), and which comprises measuring devices (8 and 9) which are connected to the output (PH) of the coincidence circuit (7) in order to count the number of pulses of the second clock signal (HR) and to elaborate consequently signals used to control the phase adjusting of the clock (3).

**FIG.1**

# FIG.2

# FIG.3

# FIG.4

EP 0 133 067 B1

# FIG. 5

FIG.6